# EUROPEAN PATENT APPLICATION

(11) **EP 2 219 417 A1**
(43) Date of publication of application: **18.08.2010**
(21) Application number: 08853057.1
(22) Date of filing: 04.11.2008
(51) Int. Cl.: H05B 33/04, G09F 9/00, G09F 9/30, H01L 27/32, H01L 51/50, H05B 33/02, H05B 33/10

(54) **ORGANIC ELECTROLUMINESCENT DEVICE AND METHOD FOR MANUFACTURING THE SAME**

(30) Priority: 22.11.2007 JP 2007303011
(71) Applicant: Sumitomo Chemical Company, Limited, Tokyo 104-8260 (JP)
(72) Inventor: MATSUE, Teruyuki, Ibaraki-shi Osaka 567-0841 (JP)
(74) Representative: Duckworth, Timothy John
(86) International application number: PCT/JP2008/070032
(87) International publication number: WO 2009/066561

(57) **Abstract**

An organic electroluminescent device comprising a supporting substrate, a sealing substrate and an organic electroluminescent element, comprising: the organic electroluminescent element mounted on the supporting substrate, and enclosed between the supporting substrate and the sealing substrate, and an insulating layer that covers the organic electroluminescent element, wherein the supporting substrate and/or the sealing substrate adhered to the insulating layer is formed of a material having thermal conductivity of 2 W/m·K or more, and wherein one surface of the supporting substrate and/or the sealing substrate formed of the material having the thermal conductivity, which is the surface constituting an exterior of the organic electroluminescent device, has surface roughness (Ra value) of 10 nm or more and 1 mm or less.

## Description

### TECHNICAL FIELD

The present invention relates to an organic electroluminescent device and a method for manufacturing the same, and particularly relates to an organic electroluminescent device comprising a supporting substrate, a sealing substrate and an organic electroluminescent element (hereinafter referred to as an "organic EL device" herein), and a method for producing the same.

### BACKGROUND ART

Various studies have been performed on organic EL devices mounted with organic electroluminescent element(s) (hereinafter referred to as an "organic EL element" herein) in order to develop the device having a higher performance.

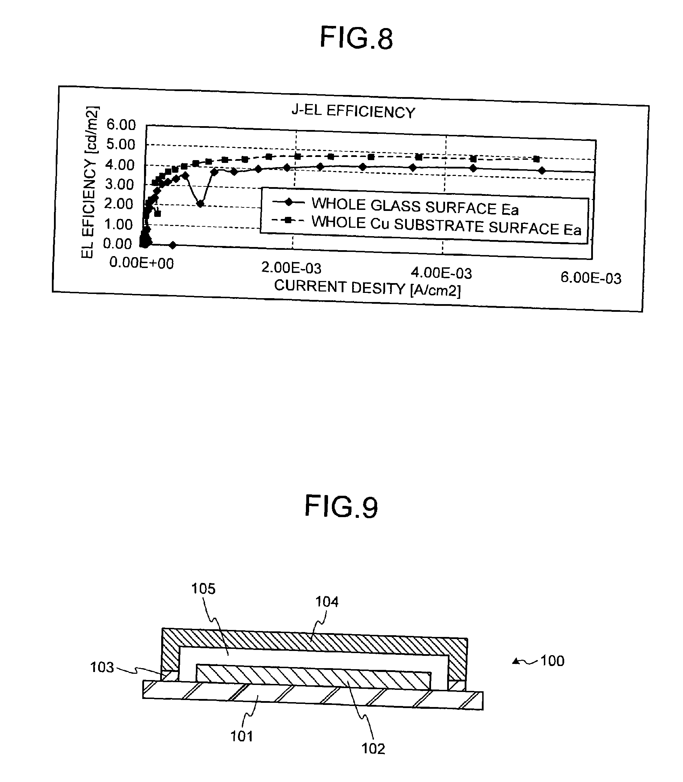

An organic EL device 100 is shown as one example of conventional organic EL devices in FIG. 9. FIG. 9 is a cross sectional view schematically showing one example of the conventional organic EL device. An organic EL element 102 is mounted on a supporting substrate 101 in the organic EL device 100. The organic EL element 102 is covered with the supporting substrate 102 and a sealing substrate 104 in order to protect the organic EL element 102 from various external factors such as physical impact and humidity. The supporting substrate 101 and the sealing substrate 104 are fixed with an adhesive material 103 in a peripheral portion surrounding the organic EL element 102 on a supporting substrate plane. As described above, the organic EL device 100 in which the organic EL element 102 was tightly sealed between the supporting substrate 101 and the sealing substrate 104 has been constituted.

The organic EL element 102 emits a light when a voltage is applied. At that time, under an present circumstance, conversion into heat energy partially occurs and the organic EL element generates heat in some cases.
It has been described that the heat generation of the organic EL element leads to reduction of a light emitting property such as brightness and deterioration of the organic EL device per se in some cases. In particular in the case of lighting devices in which the organic EL device is desired to be put into practical use, the organic EL device needs to be driven to emit the high brightness. Thus, it has become an important subject how the heat is allowed to escape from the device. Thus, various strategies have been studied to radiate the heat emitted from the organic EL device 100 to an outside of the device. For example, an aspect has been known in which a heat radiation layer having a predetermined thermal conductivity is stacked on an upper portion of a cathode in the organic EL element (e.g., Patent Document 1). Further it has been proposed that a concave portion is formed on a side of the supporting substrate opposite to a side on which the organic EL element is mounted and an aluminum plate is provided into this concave portion to diffuse the heat (e.g., patent Document 2)

Patent Document 1: JP Hei-7-111192 A
Patent Document 2: JP 2006-49057 A

### DISCLOSURE OF INVENTION

### PROBLEM TO BE SOLVED BY THE INVENTION

However, only by laminating the heat radiation layer on the upper portion of the cathode in the organic EL element, the heat radiation from the organic EL device is not sufficiently accomplished in some cases. If providing the side of the supporting substrate on which the organic EL element is not mounted with the concave portion and providing this concave portion with the heat radiative plate, it makes a structure of the device complicate in some cases. This causes an increase of manufacturing steps in some cases. By simply providing the supporting substrate and/or the sealing substrate with the heat conductive plate, the heat radiation from the organic EL device is not sufficiently accomplished in some cases. Further when the metal such as aluminum is used as the sealing substrate, the sealing substrate is brought into contact with the organic EL element by some factor to cause a disturbance such as a short-circuit in some cases.

The present invention has been made in the light of the above problems, and it is an object of the present invention to provide an organic EL device that has a simple structure, is excellent in heat radiation property and hardly causes light-emitting failure due to a disturbance such as a short-circuit. It is another object of the present invention to provide a method for simply and easily manufacturing such an organic EL device.

### MEANS FOR SOLVING PROBLEM

In order to solve the problems described above, according to the present invention, either one or both of a supporting substrate and a sealing substrate are formed of a material having a predetermined thermal conductivity, and a surface constituting an exterior has a predetermined surface roughness, thereby enhancing exothermic efficiency and uniformity of the heat distribution. Further, according to the present invention, in order to prevent a problem which may be caused by applying as such above mentioned substrate, an insulating layer is provided between the substrate and an organic EL element. Thus, the present invention provides an organic EL device and a method for manufacturing the same described below;
[1] An organic electroluminescent device comprising a supporting substrate, a sealing substrate and an organic electroluminescent element, the device comprising:
   the organic electroluminescent element mounted on the supporting substrate and enclosed between the supporting substrate and the sealing substrate, and
   an insulating layer that covers the organic electroluminescent element,
      wherein the supporting substrate and/or the sealing substrate adhered to the insulating layer is formed of a material having a thermal conductivity of 2 W/m.K or more, and
      wherein one surface of the supporting substrate and/or one surface of the sealing substrate formed of the material having the thermal conductivity, which is a surface constituting an exterior of the organic electroluminescent device, has a surface roughness (Ra value) of 10 nm or more and 1 mm or less.
[2] The organic electroluminescent device according to the above [1], wherein the thermal conductivity is 10 W/m·K or more.
[3] The organic electroluminescent device according to the above [2], wherein the material having the thermal conductivity is any one member or two or more members selected from the group consisting of metals, ceramics and inorganic oxides.
[4] The organic electroluminescent device according to the above [3], wherein the material having the thermal conductivity is one metal or a composite material of two or more members selected from the group consisting of copper, aluminum, iron, nickel, chromium, tin, alloys thereof and an SUS alloy.
[5] The organic electroluminescent device according to the above [1], wherein the supporting substrate and the sealing substrate are adhered by the insulating layer.
[6] The organic electroluminescent device according to any one of the above [1] to [5], wherein the insulating layer is formed of one member or two or more members selected from the group consisting of epoxy resin, acryl resin, polyimide resin, silicone resin, phenol resin and urethane resin.
[7] The organic electroluminescent device according to any one of the above [1] to [6], wherein the insulating layer contains a thermally conductive filler.
[8] The organic electroluminescent device according to any one of the above [7], wherein the thermally conductive filler is a fine particle of an inorganic oxide.
[9] A method for manufacturing an organic electroluminescent device by laminating a supporting substrate with an organic electroluminescent element mounted thereon and a sealing substrate,
   wherein either one of the supporting substrate or the sealing substrate or both is formed of a material having a thermal conductivity of 2 W/m.K or more, and the method comprises:
   providing the organic electroluminescent element on the supporting substrate,
   covering the organic electroluminescent element provided on the supporting substrate entirely with an insulative adhesive material having a viscosity of 10 mPa·s or more and 100 mPa·s or less before being cured,
   laminating the supporting substrate and the sealing substrate, and
   sealing the organic electroluminescent element by curing the insulative adhesive material and thereby adhering the supporting substrate and the sealing substrate.
[10] The method for manufacturing the organic electroluminescent device according to the above [9],
   wherein the viscosity of the insulative adhesive material before being cured is 20 mPa·s or more and 80 mPa·s or less.
[11] A method for manufacturing an organic electroluminescent device by laminating a supporting substrate with an organic electroluminescent element mounted thereon and a sealing substrate,
   wherein either one of the supporting substrate or the sealing substrate or both is formed of a material having a thermal conductivity of 2 W/m.K or more,and the method comprises:
   providing the organic electroluminescent element on the supporting substrate,
   applying an insulative adhesive material having a viscosity of 10 mPa·s or more and 100 mPa·s or less before being cured to one surface of the sealing substrate,
   laminating the surface with the insulative adhesive material to cover the organic electroluminescent element, and
   sealing the organic electroluminescent element by curing the insulative adhesive material under pressure due to the weight of the sealing substrate or the supporting substrate and thereby forming an insulative adhesive material layer that covers the organic electroluminescent element and adheres the supporting substrate and the sealing substrate.

### EFFECT OF THE INVENTION

According to the present invention, an organic EL device that is excellent in heat radiation property is provided. The heat distribution is uniform in the organic EL device of the present invention. The organic EL device of the present invention is excellent in exothermic efficiency and hardly causes a light emission failure due to the disturbance such as the short-circuit. Further according to the present invention, it is possible to simply and easily manufacture the organic EL device that is excellent in heat radiation property and in which the heat distribution is uniform.

### BRIEF DESCRIPTION OF DRAWINGS

FIG. 1 is a cross sectional view of a first embodiment of an organic EL device of the present invention.
FIG. 2 is a cross sectional view of a second embodiment of an organic EL device of the present invention.
FIG. 3 is a perspective view showing one embodiment of a sealing substrate of the present invention.
FIG. 4 is a perspective view showing another embodiment of the sealing substrate of the present invention.
FIG. 5 is a perspective view showing another embodiment of the sealing substrate of the present invention.
FIG. 6 is a perspective view showing another embodiment of the sealing substrate of the present invention.

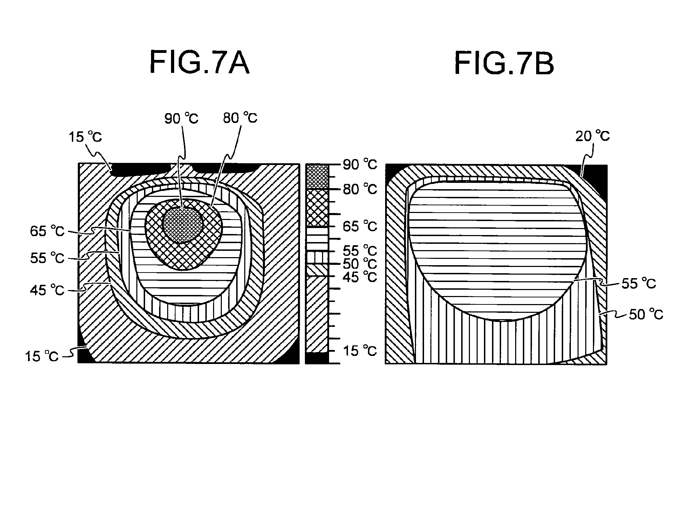

FIG.7 is a view schematically showing thermographs showing a comparison of results of measuring temperature of two different sealing substrates.
FIG. 8 is a graph showing results of measuring an electroluminescence (EL) efficiency.
FIG. 9 is a view showing one example of a conventional organic EL device.

### EXPLANATIONS OF LETTERS OR NUMERALS

- 1A, 1B, 1C: ORGANIC EL DEVICE
- 10: SUPPORTING SUBSTRATE
- 20: ORGANIC EL ELEMENT
- 30, 31: SEALING SUBSTRATE
- 30a, 30b, 30c, 30d: SEALING SUBSTRATE
- 40, 41: INSULATING LAYER (SEALING MATERIAL)
- 50: ADHESIVE MATERIAL
- 100: ORGANIC EL DEVICE (CONVENTIONAL)
- 101: SUPPORTING SUBSTRATE
- 102: ORGANIC EL ELEMENT
- 103: ADHESIVE MATERIAL
- 104: SEALING SUBSTRATE
- 105: AIR SPACE

### BEST MODES FOR CARRYING OUT THE INVENTION

The embodiments of the present invention will be described below with reference to the drawings. For easy understanding, a scale of each member is different from an actual scale in the drawings in some cases. The present invention is not limited by the following description, and can be appropriately altered within the range not departing from the gist of the present invention. Further, in the organic EL device, the members such as lead wires of electrodes are also present, but their description is omitted because they are not directly associated with the description of the present invention.

### 1. Organic EL device of the present invention

### [First embodiment]

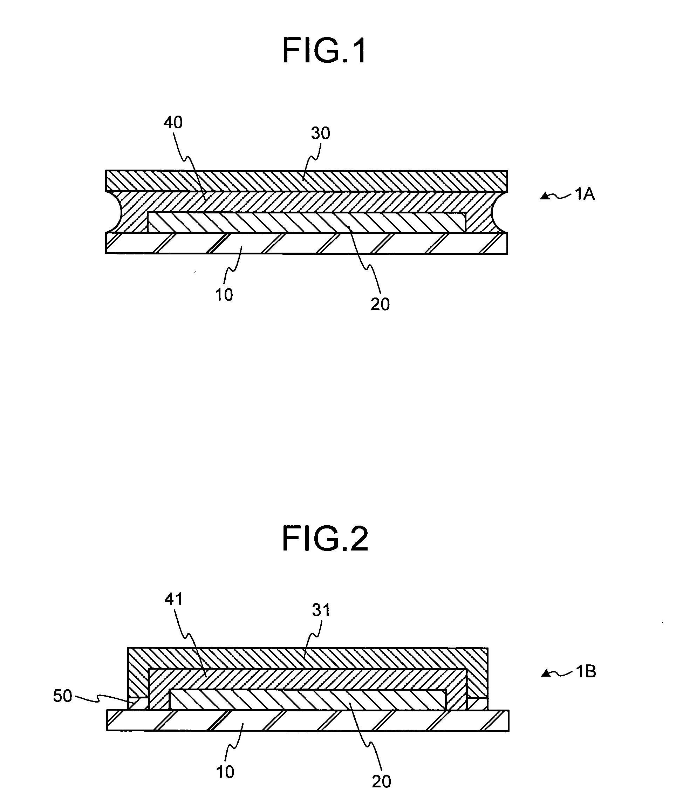

The first embodiment of the organic EL device of the present invention will be described with reference to FIG. 1. FIG. 1 is a cross sectional view of the organic EL device 1A in the first embodiment. An organic EL element 20 is mounted on a supporting substrate 10. An upper plane of the organic EL device 20 is covered with a sealing substrate 30. That is, the organic EL device 2 is enclosed with the supporting substrate 10 and the sealing substrate 30. The supporting substrate 10 and the sealing substrate 30 are mutually adhered and fixed by an insulating layer 40 (sealing material). The insulating layer 40 is constituted as the layer sandwiched with the supporting substrate 10 and the sealing substrate 30. The insulating layer 40 (sealing material) entirely covers the organic EL device 20 on the supporting substrate 10, the organic EL element 20 is shielded from ambient air by the insulating layer 40, and thus the organic EL device 1A is sealed. That is, the organic EL element 20 is shielded from the ambient air and protected from physical and mechanical impacts by means of the supporting substrate 10, the insulating layer (sealing material) 40 and the sealing substrate 30 in the organic EL device 1A. In the first embodiment, peripheral edges of the organic EL element 20 on the plane of the supporting substrate need not be sealed with an adhesive agent separately obtained because the organic EL device 1A is sealed with the sealing material that forms the insulating layer 40.

In the first embodiment, the sealing substrate 30 is formed of a material having thermal conductivity at a predetermined level or more. The thermal conductivity is at least 2 W/m·K or more, preferably 10 W/m·K or more, and more preferably 50 W/m.K or more. By using the material having such thermal conductivity at the predetermined level, the heat distribution in the organic EL device 1A can be uniformized, as well as the heat radiation property can be enhanced. From such a point of view, it is not particularly required to define an upper limit of the thermal conductivity in the present invention. The numerical value of the thermal conductivity shown herein can be obtained by a method in accordance with a laser flash method JIS R1611 (version 1997), and the thermal conductivity can be calculated from measured values of a specific heat and a thermal diffusion rate at normal temperature.

A surface that constitutes an exterior of the sealing substrate 30, i.e., a surface opposite to a surface facing to the supporting substrate has a predetermined surface roughness surface roughness (Ra value). The surface roughness (Ra value) is 10 nm or more and 1 mm or less, preferably 20 nm or more and 1 mm or less and more preferably 1 µm or more and 1 mm or less. By making the sealing substrate having the surface roughness (Ra value) of such a predetermined value or more, the heat radiation property can be enhanced. It is not required in terms of heat radiation property to provide the upper limit of the surface roughness (Ra value). However, if the surface is too rough, it is likely that fine projection portions on the surface crack partially to produce pieces and that small foreign matters such as powder dusts adhere to and deposit on the rough surface. Thus, by providing the surface roughness with the above upper limit, the heat radiation property is enhanced, as well as a damage on the surface of the sealing substrate 30 can be prevented and the adhesion and the deposition of the small foreign matters such as powder dusts can be prevented.

The exterior of the sealing substrate 30 is not particularly limited as to its shape and like, as long as its surface has the predetermined surface roughness (Ra value). The shape of the exterior of the sealing substrate 30 will be separately described later in detail for some shapes as a fourth to sixth embodiments. The numerical value of the surface roughness (Ra) shown herein can be measured using a probe mode surface roughness measuring instrument, a light wave interference mode surface roughness measuring instrument or AFM (atomic force microscope) and the like.

Examples of materials having the predetermined heat conductivity may preferably include one member, or a composite of two or more members, selected from the group consisting of metals, ceramics and inorganic oxides. Examples of the preferable metals may include one member, or a composite of two or more members, selected from the group consisting of copper, aluminum, iron, nickel, chromium and tin. Examples of the composites may include an alloy of two or more members selected from copper, aluminum, iron, nickel, chromium and tin as well as an SUS alloy (stainless steel alloy). The copper may be preferably included in terms of easiness of processing and obtaining and cost cutting.

When the sealing substrate 30 formed of the material having the predetermined heat conductivity and a surface roughness (Ra value) is opaque, a substrate having a transparency is employed as the supporting substrate 10, and then a so-called bottom emission type of organic EL device is made in which the light emitted from the organic EL element 20 is collected from the side of the supporting substrate 10.

The substrate having the predetermined heat conductivity and the predetermined surface roughness may have a monolayer structure or a multilayer structure as long as one surface constituting an exterior of the device is composed so as to have the predetermined surface roughness. For example, in the organic EL device 1A shown in FIG. 1, a layer may be further provided between the sealing substrate 30 and the insulating layer 40. Also in the organic EL device 1A shown in FIG. 1, a layer may further be inserted between the supporting substrate 10 and the organic EL element 20.

In the first embodiment, the insulating layer 40 is formed with the sealing material. As described above, the material having the predetermined heat conductivity is used in the present invention. Such a material often has an electric conductivity. A thickness of the organic EL device 1A is about 100 µm or more and 5 mm or less. The thickness of the sealing substrate 30 is approximately several tens µm to 5 mm. A distance between the organic EL element 20 and the sealing substrate is preferably 100 nm or more and 1 mm or less and more preferably 1 µm or more and 0.5 mm or less. It is likely further thinner in the future. Thus, even if a marginal external pressure is added, it is likely that the sealing substrate 30 easily contacts with an upper surface of the organic EL element 20 to cause the short-circuit. Therefore, in the present invention, the organic EL element 20 on the supporting substrate 10 is entirely covered with the sealing material having an insulative property to form the insulating layer 40 between the sealing substrate 30 and the organic EL element 20. By making such a constitution, the organic EL device 1A can be sealed by the simple constitution, as well as various materials having the predetermined heat conductivity can be employed as the sealing substrate.

An interval between the sealing substrate 30 and the upper surface of the organic EL element 20 facing thereto is preferably 10 nm or more and 1 mm or less and more preferably 1 µm or more and 0.5 mm or less. By making such an interval, it is possible to form the insulating layer that can prevent the short-circuit without inhibiting the heat radiation property. The thickness of the organic EL device itself can be kept as a thin type.

The insulating layer 40 is provided all over between the organic EL element 20 and the sealing substrate 30 and employs the constitution to prevent the short-circuit capable of being caused by the sealing substrate 30. Examples of materials forming the insulating layer 40 may include preferably one or two or more composites of epoxy resin, acryl resin, polyimide resin, silicone resin, phenol resin and urethane resin. In the first embodiment, the insulating layer 40 also bears a function as the sealing material that shields the organic EL element 20 from the outside. Further, the insulating layer 40 has a function as an adhesive material that fixes the supporting substrate 10 and the sealing substrate 30. That is, in the first embodiment, it is preferable to employ the material that is excellent in insulative property, adhesiveness and ambient air-shielding property as the insulating layer 40. From such a point of view, the materials forming the insulating layer 40 may include preferably the epoxy resin, the acryl resin, the polyimide resin, the silicone resin, the phenol resin and the urethane resin.

The thickness of the insulating layer 40 between the supporting substrate 10 and the sealing substrate 30 is preferably 300 nm or more and 1 mm or less and more preferably 1 µm or more and 1 mm or less. Depending on the material forming the insulating layer, by making the thickness the above lower limit or more, the layer can be made which is excellent in insulative property, shielding property and adhesiveness. On the other hand, by making the above upper limit or less, the thickness of the entire organic EL device 1A can be thinned.

The insulating layer may contain a thermally conductive filler. The material that can accessorily facilitate the heat radiation and does not give the disturbance to the organic EL element may be employed as the thermally conductive filler. Examples of the thermally conductive filler may include inorganic oxides, preferably include silica, ceria, alumina and titania. When the inorganic oxide is contained as the thermally conductive filler, it is preferable to use fine particles of the inorganic oxide. A particle diameter of the fine particle is preferably 2 nm or more and 5 µm or less, and more preferably 5 nm or more and 1 µm or less. Preferable one embodiment may include an embodiment in which the fine particles of the inorganic oxide are dispersed in the insulating layer. When the thermally conductive filler is used, a thermally conductive sheet containing this may be made and provided as an optional layer between the sealing substrate 30 and the insulating layer 40 or between the supporting substrate 10 and the organic EL element 20. The thermally conductive sheet can be produced by dispersing the fine particles of the thermally conductive filler in a resin substrate and processing this into a thin film. By using the thermally conductive filler, it is possible to make the organic EL device that is more excellent in heat radiation property and uniform distribution of the heat.

The substrate that is not required to be the substrate having the predetermined thermal conductivity and surface roughness, i.e., the supporting substrate 10 in the first embodiment, can be those that is not changed upon forming a layer of an organic matter, and for example, a glass, a plastic, a polymer film, a silicon substrate or a laminated one thereof is used. Such a substrate is commercially available or can be produced by a publicly known method.

By providing the sealing substrate 30 comprising the predetermined thermal conductivity and the predetermined surface roughness as described above, the heat generated upon applying voltage to the organic EL element 20 can be smoothly released to uniformize the thermal distribution in the organic EL device 1A. Due to a good heat radiation property and uniformization of the thermal distribution, the reduction of the electroluminescence efficiency and the brightness caused by the heat can be prevented in the organic EL device 1A. The sealing material 40 has not only the function of sealing but also the function as the insulating layer and the function of fixing the substrates each other, and thus the uniform thermal distribution and the excellent heat radiation property are accomplished by the extremely simple constitution in the organic EL device 1A in the first embodiment.

Subsequently, an embodiment of a layer constitution (not shown in a figure) of the organic EL element 20 will be described more specifically.

The organic EL element 20 essentially has an anode, a light-emitting layer and a cathode, and in addition may have other layer(s) between the anode and the light-emitting layer, and/or between the light emitting layer and the cathode.

The layer that may be provided between the cathode and the light-emitting layer may include an electron injection layer, an electron transport layer and a hole block layer. When both the electron injection layer and the electron transport layer are provided, the layer closer to the cathode is the electron injection layer and the layer closer to the light-emitting layer is the electron transport layer.

The electron injection layer is the layer having a function of improving an electron injection efficiency from the cathode. The electron transport layer is the layer having a function of improving an electron injection from the cathode, the electron injection layer or the electron transport layer closer to the cathode. When the electron injection layer or the electron transport layer has a function of blocking the transport of holes, these layers sometimes double as the hole block layer.

The layer provided between the anode and the light-emitting layer may include a hole injection layer, a hole transport layer and an electron block layer. When both the hole injection layer and the hole transport layer are provided, the layer closer to the anode is the hole injection layer, and the layer closer to the light-emitting layer is the hole transport layer.

The hole injection layer is the layer having a function of improving a hole injection efficiency from the anode, and the hole transport layer is the layer having a function of improving a hole injection from the anode, the hole injection layer and the hole transport layer closer to the anode. When the hole injection layer or the hole transport layer has a function of blocking the transport of electrons, these layers sometimes double as the electron block layer.

Typically, one layer is provided as the light-emitting layer, but the layer is not limited thereto, and two or more light-emitting layers may also be provided in the organic EL element 20. In that case, the two or more light-emitting layers may be stacked in direct contact. The layer such as a metal oxide layer used in the present invention may also be provided between the two or more light-emitting layers one another.

The electron injection layer and the hole injection layer are sometimes collectively referred to as a charge injection layer. The electron transport layer and the hole transport layer are sometimes collectively referred to as a charge transport layer.

More specifically, the organic EL element 20 may have any of the following layer constitutions:
a) Anode/Hole transport layer/Light-emitting layer/Cathode
b) Anode/Light-emitting layer/Electron transport layer/Cathode
c) Anode/Hole transport layer/Light-emitting layer/Electron transport layer/Cathode
d) Anode/Charge injection layer/Light-emitting layer/Cathode
e) Anode/Light-emitting layer/Charge injection layer/Cathode
f) Anode/Charge injection layer/Light-emitting layer/Charge injection layer/Cathode
g) Anode/Charge injection layer/Hole transport layer/Light-emitting layer/Cathode
h) Anode/Hole transport layer/Light-emitting layer/Charge injection layer/Cathode
i) Anode/Charge injection layer/Hole transport layer/Light-emitting layer/Charge injection layer/Cathode
j) Anode/Charge injection layer/Light-emitting layer/Charge transport layer/Cathode
k) Anode/Light-emitting layer/Electron transport layer/Charge injection layer/Cathode
l) Anode/Charge injection layer/Light-emitting layer/Electron transport layer/Charge injection layer/Cathode
m) Anode/Charge injection layer/Hole transport layer/Light-emitting layer/Charge transport layer/Cathode
n) Anode/Hole transport layer/Light-emitting layer/Electron transport layer/Charge injection layer/Cathode, and
o) Anode/Charge injection layer/Hole transport layer/Light-emitting layer/Electron transport layer/Charge injection layer/Cathode.
(Here a slash indicates that each layer is stacked adjacently. Hereinafter the same meaning shall apply.)

The metal oxide layer is provided as at least one layer of the charge injection layer, the hole transport layer, the electron transport layer or the charge injection layer in each example of the above layer constitutions.

The organic EL element 20 may have two or more light-emitting layers.
The organic EL element having the two light-emitting layers may include specifically those having the layer constitution of: p) Anode/Charge injection layer/Hole transport layer/Light-emitting layer/Electron transport layer/Charge injection layer/Electrode/Charge injection layer/Hole transport layer/Light-emitting layer/Electron transport layer/Charge injection layer/Cathode.
The organic EL element having three or more light-emitting layers may include specifically those having the layer constitution of:
q) Anode/Charge injection layer/Hole transport layer/Light-emitting layer/Electron transport layer/Charge injection layer/Repeating unit A/Repeating unit A/..../Cathode including two or more repeating units A, wherein the repeating unit A is Electrode/Charge injection layer/Hole transport layer/Light-emitting layer/Electron transport layer/Charge injection layer.
In the above layer constitutions p) and q), each layer other than the anode, the electrode, the cathode and the light-emitting layer may be omitted if necessary.
Here, the electrode is the layer that generates the hole and the electron by applying an electric voltage. Examples of a material that constitutes the electrode may include vanadium oxide, indium tin oxide and molybdenum oxide.
The metal oxide layer is provided as at least one layer of the charge injection layer, the hole transport layer and the electrode in each example of p) and q) in the above constitution.

In the organic EL element 20, typically all of the layers on any one side of the light-emitting layer are transparent in order to release the light from the light-emitting layer. Specifically for example, in the case of the organic EL element having the constitution of Anode/Charge injection layer/Hole transport layer/Light-emitting layer/Electron transport layer/Charge injection layer/Cathode/Sealing member, all of Anode/Charge injection layer and Hole transport layer are made transparent to make a so-called bottom emission type element, or all of the electron transport layer, the charge injection layer, the cathode and the sealing member may be made transparent to make a so-called top emission type element. In the case of the organic EL element having the constitution of Cathode/Charge injection layer/Electron transport layer/Light-emitting layer/Hole transport layer/Charge injection layer/Anode/Sealing member, all of the cathode, the charge injection layer and the electron transport layer may be made transparent to make the so-called bottom emission type element, or all of the hole transport layer, the charge injection layer, the anode and the sealing member may be made transparent to make the so-called top emission type element. Here, the transparency preferably means that the transmittance of the visible light from the light-emitting layer to the layer from which the light is released is 40% or more. In the case of the element in which the light emission is required in an ultraviolet region or an infrared region, it is preferable to have the transmittance of 40% or more in the relevant region.

In the organic EL element 20, the charge injection layer or an insulating layer having a film thickness of 2 nm or less may be further provided adjacently to the electrode in order to enhance tight adhesiveness to the electrode and improve the charge injection from the electrode, and a thin buffer layer may be inserted in an interface of the charge transport layer or the light-emitting layer in order to enhance the tight adhesiveness of the interface and prevent blending.
The order and the number of the layers to be stacked and the thickness of each layer can be appropriately determined by taking the electroluminescence efficiency and an element lifetime into account.

Subsequently, the materials of each layer and the methods for forming each layer that composes the organic EL element 20 will be described more specifically.

### <Anode>

As the anode of the organic EL element 20, it is preferable to use a transparent or translucent electrode because the element that emits the light through the electrode can be constituted. As such a transparent electrode or translucent electrode, it is possible to use a thin film of metal oxide, metal sulfide or a metal having a high electric conductivity. Those having a high transmittance can be suitably utilized as the anode, and the anode are appropriately selected and used depending on an organic layer to be used. Specifically, films, such as NESA, which are formed by using conductive glasses made from those such as indium oxide, zinc oxide, tin oxide, and complexes thereof such as indium tin oxide (ITO) and indium zinc oxide, as well as gold, platinum, silver and copper are employed, and ITO, indium zinc oxide and tin oxide are preferable. The method for forming the anode may include a vacuum deposition method, a sputtering method, an ion plating method and a plating method. An organic transparent conductive film of polyaniline or a derivative thereof or polythiophene or a derivative thereof may be used as the anode.
A material that reflects the light may be used for the anode, and the metal, the metal oxide or the metal sulfide, having a work function of 3.0 eV or more, is preferable as the material.

The film thickness of the anode can be appropriately selected in consideration of light transmission and the electric conductivity. The film thickness of the anode is, for example, 10 nm to 10 µm, preferably 20 nm to 1 µm and more preferably 50 nm to 500 nm.

### <Hole injection layer>

The hole injection layer may be provided between the anode and the hole transport layer or between the anode and the light-emitting layer. The metal oxide layer may be used as the hole injection layer in the particularly preferable aspect of the present invention.
When the organic EL element of the present invention has the metal oxide layer as the layer other than the hole injection layer, the materials that form the hole injection layer may include phenylamine-based compounds, starburst type amine-based compounds, phthalocyanine-based compounds, oxides such as vanadium oxide, tantalum oxide, tungsten oxide, molybdenum oxide, ruthenium oxide and aluminum oxide, amorphous carbon, polyaniline and polythiophene derivatives.

### <Hole transport layer>

The metal oxide layer may be used as the hole transport layer in some cases. However, in the cases other than it, examples as the materials that constitute the hole transport layer may include polyvinylcarbazole or derivatives thereof, polysilane or derivatives thereof, polysiloxane derivatives having aromatic amine in a side chain or a main chain, pyrazoline derivatives, arylamine derivatives, stilbene derivatives, triphenyldiamine derivatives, polyaniline or derivatives thereof, polythiophene or derivatives thereof, polyarylamine or derivatives thereof, polypyrrole or derivatives thereof, poly(p-phenylene vinylene) or derivatives thereof, and poly(2,5-thienylene vinylene) or derivatives thereof.

Among them, as the hole transport materials used for the hole transport layer, preferable are polymer hole transport materials such as polyvinylcarbazole or the derivatives thereof, polysilane or the derivatives thereof, the polysiloxane derivatives having aromatic amine in the side chain or the main chain, polyaniline or the derivatives thereof, polythiophene or the derivatives thereof, polyarylamine or the derivatives thereof, poly(p-phenylene vinylene) or the derivatives thereof, and poly(2,5-thienylene vinylene) or the derivatives thereof, and more preferable are polyvinylcarbazole or the derivatives thereof, polysilane or the derivatives thereof and the polysiloxane derivatives having aromatic amine in the side chain or the main chain. When the hole transport material is a low molecule, it is preferable to use by being dispersed in a polymer binder.

The method of forming a film of the hole transport layer is not limited, but an example for the hole transport material with a low molecular weight is a method of forming the film from a mixed solution with the polymer binder. An example for the hole transport material with a high molecular weight is a method of forming the film from the solution.

The solvent used for forming the film from the solution is not particularly limited as long as the hole transport material is dissolved therein. Examples of the solvent may include chlorine-base solvents such as chloroform, methylene chloride and dichloroethane, ether-based solvents such as tetrahydrofuran, aromatic hydrocarbon-based solvents such as toluene and xylene, ketone-based solvent such as acetone and methyl ethyl ketone, and ester-based solvents such as ethyl acetate, butyl acetate and ethyl cellsolve acetate.

As the method of forming the film from the solution, usable methods are applying methods such as coating methods e.g., a spin coating method, a casting method, a microgravure coating method, a gravure coating method, a bar coating method, a roll coating method, a wire bar coating method, a dip coating method, a slit coating method, a capillary coating method, a spray coating method and a nozzle coating method, and printing methods e.g., a gravure printing method, a screen printing method, a flexographic printing method, an offset printing method, a reverse printing method and an inkjet printing method from the solution. In terms of easy pattern formation, preferable are the printing methods such as the gravure printing method, the screen printing method, the flexographic printing method, the offset printing method, the reverse printing method and the inkjet printing method.

As the polymer binder to be mixed, those which do not inhibit the charge transport excessively are preferable and those having a mild absorption of the visible light are suitably used. Examples of polymer binder may include polycarbonate, polyacrylate, polymethyl acrylate, polymethyl methacrylate, polystyrene, polyvinyl chloride and polysiloxane.

The film thickness of the hole transport layer has a varying optimal value depending on the material to be used, and may be selected so that a driving voltage and the electroluminescence efficiency have an appropriate value. The film thickness of the hole transport layer needs the thickness at least not to cause a pinhole. When the thickness is too thick, it is likely that the driving voltage of the element becomes high. Therefore, the film thickness of the hole transport layer is, for example, 1 nm to 1 µm, preferably 2 nm to 500 nm and more preferably 5 nm to 200 nm.

### <Light-emitting layer>

The light emitting layer is preferably an organic light emitting layer in the present invention. The light-emitting layer typically has an organic matter (low molecular compound and high molecular compound) that mainly emits fluorescence or phosphorescence. The light-emitting layer may further contain a dopant material. Materials that form the light-emitting layer that may be used in the present invention may include, for example, the following dyestuff-based materials, metal complex-based materials, polymer-based materials and dopant materials.

### [Dyestuff-based materials]

Examples of the dyestuff-based material may include cyclopendamine derivatives, tetraphenylbutadiene derivative compounds, triphenylamine derivatives, oxadiazole derivatives, pyrazoloquinoline derivatives, distyrylbenzene derivatives, distyrylarylene derivatives, pyrrole derivatives, thiophene ring compounds, pyridine ring compounds, perinone derivatives, perylene derivatives, oligothiophene derivatives, oxadiazole dimers and pyrazoline dimers.

### [Metal complex-based materials]

Examples of the metal complex-based material may include metal complexes having the luminescence from a triplet excitation state such as iridium complexes and platinum complexes; and metal complexes having A1, Zn, Be or a rare earth metal such as Tb, Eu or Dy as a center metal and having an oxadiazole, thiadiazole, phenylpyridine, phenylbenzimidazole or quinoline structure as a ligand, such as an aluminum quinolinol complex, a benzoquinoline beryllium complex, a benzoxazolyl zinc complex, a benzothiazole zinc complex, an azomethyl zinc complex, a porphyrin zinc complex, and an europium complex.

### [Polymer-based materials]

Examples of the polymer-based materials may include polyparaphenylene vinylene derivatives, polythiophene derivatives, polyparaphenylene derivatives, polysilane derivatives, polyacetylene derivatives, polyfluorene derivatives, polyvinylcarbazole derivatives, and those obtained by polymerizing the above dyestuff-based or the metal complex-based light-emitting materials.
Among the above light-emitting materials, the material that emits blue light may include distyrylarylene derivatives, oxadiazole derivatives and polymers thereof, polyvinylcarbazole derivatives, polyparaphenylene derivatives and polyfluorene derivatives. Among them, the polyvinylcarbazole derivatives, the polyparaphenylene derivatives and the polyfluorene derivatives, which are the polymer materials, are preferable as the materials that emit the blue light.
The material that emits green light may include quinacridone derivatives, coumarin derivatives and polymers thereof, polyparaphenylene vinylene derivatives and polyfluorene derivatives. Among them, the polyparaphenylene vinylene derivatives and the polyfluorene derivatives, which are the polymer materials, are preferable as the materials that emit the green light.
The material that emits red light may include coumarin derivatives, thiophene ring compounds and polymers thereof, polyparaphenylene vinylene derivatives, polythiophene derivatives and polyfluorene derivatives. Among them, the polyparaphenylene vinylene derivatives, the polythiophene derivatives and the polyfluorene derivatives, which are the polymer materials, are preferable as the materials that emit the red light.

### [Dopant materials]

A dopant may be added in the light emitting layer for the purpose of enhancing the electroluminescence efficiency and changing a luminescence wavelength. Examples of such a dopant may include perylene derivatives, coumarin derivatives, rubrene derivatives, quinacridone derivatives, squarium derivatives, porphyrin derivatives, styryl-based dyestuffs, tetracene derivatives, pyrazolone derivatives, decacyclene and phenoxazone. The thickness of such a light emitting layer is generally about 20 to 2000 angstroms.

### <Method of forming film of light emitting layer>

As the method of forming the film of the light emitting layer containing the organic matter, the method of applying the solution containing the light emitting material on or above the substrate, the vacuum deposition method or a transfer method may be used. Specific examples of solvents used for forming the film from a solution may include the same solvents as those in which the hole transfer material is dissolved when the film of the hole transfer layer is formed from the solution.
Usable methods of applying the solution containing the light emitting material on or above the substrate may include the applying methods: coating methods such as the spin coating method, the casting method, the micro-gravure coating method, the gravure coating method, the bar coating method, the roll coating method, the wire bar coating method, the dip coating method, the slit coating method, the capillary coating method, the spray coating method and the nozzle coating method; and printing methods such as the gravure printing method, the screen printing method, the flexographic printing method, the offset printing method, the reverse printing method and the inkjet printing method. In terms of easy pattern formation and easy color coding, the preferable methods of applying the solution containing the light emitting material are the printing methods such as the gravure printing method, the screen printing method, the flexographic printing method, the offset printing method, the reverse printing method and the inkjet printing method. When the light-emitting material is a sublimable low molecular compound, the vacuum deposition method may be used. In addition, the light emitting layer may be formed only on a desired place by laser transfer or thermal transfer.

### <Electron transport layer>

The metal oxide layer may be used as the electron transport layer in some cases. However, in the cases other than it, those known publicly may be used as the electron transfer layer, and examples thereof may include oxadiazole derivatives, anthraquinodimethane or derivatives thereof, benzoquinone or derivatives thereof, naphthoquinone or derivatives thereof, anthraquinone or derivatives thereof, tetracyanoanthraquinodimethane or derivatives thereof, fluorenone derivatives, diphenyldicyanoethylene or derivatives thereof, diphenoquinone derivatives, or metal complexes of 8-hydroxyquinoline or derivatives thereof, polyquinoline or derivatives thereof, polyquinoxaline or derivatives thereof, and polyfluorene or derivatives thereof.

Among them, preferable are the oxadiazole derivatives, benzoquinone or the derivatives thereof, anthraquinone or the derivatives thereof, or the metal complexes of 8-hydroxyquinoline or the derivatives thereof, polyquinoline or the derivatives thereof, polyquinoxaline or derivatives thereof, and polyfluorene or derivatives thereof, and more preferable are 2-(4-biphenylyl)-5-(4-t-butylphenyl)-1,3,4-oxadiazole, benzoquinone, anthraquinone, tris(8-quinolinol)aluminum and polyquinoline.

Methods of forming the film of the electron transfer layer are not particularly limited, but examples for electron transfer materials with a low molecular weight may include the vacuum deposition method from powder or the method of forming the film from the solution or a melted state. Examples for the electron transfer materials with a high molecular weight may include methods of forming the film from the solution or the melted state. The polymer binder may be combined when the film is formed from the solution or the melted state. The method of forming the film of the electron transfer layer from the solution may include the same methods of forming the film as the aforementioned method of forming the film of the hole transfer layer from the solution.

The film thickness of the electron transport layer has a varying optimal value depending on the material to be used, and may be selected so that the driving voltage and the electroluminescence efficiency have the appropriate value. However, the film thickness of the electron transport layer needs the thickness at least not to cause the pinhole. When the thickness is too thick, it is likely that the driving voltage of the element becomes high. Therefore, the film thickness of the electron transport layer is, for example, 1 nm to 1 µm, preferably 2 nm to 500 nm and more preferably 5 nm to 200 nm.

### <Electron injection layer>

The electron injection layer is provided between the electron transfer layer and the cathode or between the light emitting layer and the cathode. The metal oxide layer may be used as the electron injection layer in some cases. However, in the cases other than it, materials of the electron injection layer may include alkali metals, alkali earth metals, or alloys containing one or more of the aforementioned metals, or oxide, halide and carbonate of the aforementioned metals, or mixtures of the aforementioned metals depending on the type of the light emitting layer. Examples of the alkali metals and oxide, halide and carbonate thereof may include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride and lithium carbonate. Examples of the alkali earth metal, and oxide, halide and carbonate thereof may include magnesium, calcium, barium, strontium, magnesium oxide, magnesium fluoride, calcium oxide, calcium fluoride, barium oxide, barium fluoride, strontium oxide, strontium fluoride and magnesium carbonate. The electron injection layer may be one obtained by stacking two or more layers. Specifically, the electron injection layer may include a LiF/Ca stacked body. The electron injection layer is formed by the deposition method, the sputtering method or the printing method. The film thickness of the electron injection layer is preferably about 1 nm to 1 µm.

### <Cathode materials>

As the materials of the cathode used in the organic EL element, the material in which the work function is small and the electron is easily injected into the light emitting layer and/or the material in which the electric conductivity is high and/or the material in which a reflectance of the visible light is high is preferable. As the metals, the alkali metals, the alkali earth metals, transition metals and metals in Group 13 may be used. Usable examples may include: metals such as lithium, sodium, potassium, rubidium, cesium, beryllium, magnesium, calcium, strontium, barium, aluminum, scandium, vanadium, zinc, yttrium, indium, cerium, samarium, europium, terbium and ytterbium; alloys of two or more of the above metals; or alloys of one or more of the above metals and one or more of gold, silver, platinum, copper, manganese, titanium, cobalt, nickel, tungsten and tin; or graphite or graphite intercalational compounds. Examples of the alloy may include magnesium/silver alloys, magnesium/indium alloys, magnesium/aluminum alloys, indium/silver alloys, lithium/aluminum alloys, lithium/magnesium alloys, lithium/indium alloys and calcium/aluminum alloys. A transparent conductive electrode may also be used as the cathode. Examples usable as the materials of the transparent conductive electrode may include conductive metal oxides and conductive organic matters. Specifically, indium oxide, zinc oxide, tin oxide, and indium tin oxide (ITO) and indium zinc oxide (IZO) that are complexes thereof may be used as the conductive metal oxide, and organic transparent conductive films of polyaniline or derivatives thereof and polythiophene or derivatives thereof may be used as the conductive organic matters. The cathode may be formed into a laminated structure of two or more layers. The electron injection layer is used as the cathode in some cases.

The film thickness of the cathode can be appropriately selected in consideration of electric conductivity and durability. The film thickness of the cathode is, for example, 10 nm to 10 µm, preferably 20 nm to 1 µm and more preferably 50 nm to 500 nm.

The vacuum deposition method, the sputtering method or a laminate method in which a metal thin film is bonded with pressure is used as the method for forming the cathode.

The organic EL element of the present invention can be used as a planer light source as well as a backlight of a segment display device, a dot matrix display device and the liquid crystal display device.

In order to obtain planarly emitted light using the organic EL element of the present invention, the planar anode and cathode can be disposed to be superimposed mutually. In order to obtain the emitted light having a pattern, the method in which a mask provided with windows having the pattern is disposed on the surface of the planar light emitting element, the method in which the organic layer in a non-light emitting portion is extremely thickened to substantially not emit the light and the method in which either or both the anode or/and the cathode are formed to have the pattern are available. A segment type display device that can display numerals, letters and simple signs is obtained by forming the pattern using any of the above methods and disposing some electrodes so as to be turned ON/OFF independently. Furthermore, in order to make a dot matrix element, both the anode and the cathode can be formed to have stripes and disposed to be mutually orthogonalized. A partial color display and a multicolor display become possible by separately applying multiple kinds of the light emitting materials having the different light color or using a color filter or a fluorescence conversion filter. The dot matrix element can be driven passively or may be driven actively in combination with TFT. These display elements can be used as the display devices of computers, televisions, mobile terminals, mobile phones, car navigations and view finders of video cameras.

Additionally, the planar light emitting device is a self-luminescent thin type, and can be used suitably as the planar light source for the backlight of the liquid crystal display device or as the light source for planar lightings. If a flexible substrate is used, this light emitting device can be used as the light source and the display device having a curved surface.

### [Second embodiment]

Subsequently, the second embodiment of the present invention will be described with reference to FIG. 2. FIG. 2 is a cross sectional view of an organic EL device 1B of the second embodiment. The same symbol is given to the same constitution as in the above first embodiment, and its description is omitted.
In the first embodiment, the tabular substrate was used as the sealing substrate 30, but in the second embodiment, the substrate having a concave portion that encloses the upper surface and side surfaces of the organic EL element 20 is used as a sealing substrate 31. The sealing substrate 31 is arranged so that its concave portion is faced to the organic EL element 20. In FIG. 2, the concave portion of the sealing substrate 31 is placed downward, and the sealing substrate 31 is attached with the supporting substrate 10. The sealing substrate 31 is fixed to the supporting substrate 10 with the adhesive material provided at a peripheral edge of the organic EL element 20 to produce the constitution in which the organic EL device 1B is sealed. The sealing substrate 31 and an insulating layer 41 are entirely present between the organic EL element 20 and the sealing substrate 31 and prevent the short-circuit that may be caused by the sealing substrate 31. As the material that forms the insulating layer 41, those shown as the examples in the first embodiment may be employed. In the second embodiment, however, the supporting substrate 10 and the sealing substrate 31 are fixed with the adhesive material 50; therefore, the material that forms the insulating layer 41 may be selected without emphasizing the adhesiveness like in the first embodiment. In the second embodiment, the organic EL element 20 is entirely enclosed with the supporting substrate 10 and the sealing substrate 31 via the adhesive material 50, and sealed inside thereof; therefore, the material of the insulating layer 41 need not be necessarily selected by focusing on the shielding function from the ambient air.

The adhesive material 50 may be employed from those used as the adhesive material (or also referred to as a shield material) for sealing in the art of the organic EL device. Examples of the adhesive material 50 may include epoxy resins, acryl resins, polyimide resins, silicone resins, phenol resins, and urethane resins.

### [Third embodiment]

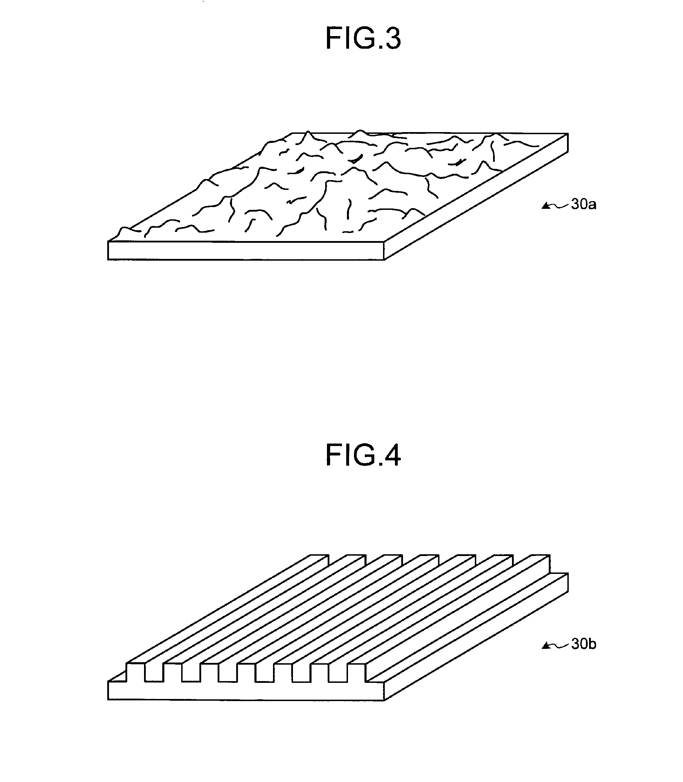

A third embodiment will be described with reference to FIG. 3. The third embodiment is either one of the supporting substrate or the sealing substrate, which formed of the material having the predetermined thermal conductivity, and shows one form of an exterior surface of the substrate in which the surface that composes the exterior has the predetermined surface roughness (Ra value). The exterior surface is the surface opposite to the surface faced to the organic EL element 20.
FIG. 3 is a perspective view schematically showing a part 30a of the exterior surface of the sealing substrate 30 in the first embodiment. The exterior surface 30a is provided with random asperities. The value of the surface roughness (Ra) of the exterior surface 30a is the above predetermined value or more. The method of forming such random asperities is not particularly limited, and the random asperities may be formed by, for example, polish with a polishing material or a press working.
The exterior surface of the shape as shown in FIG. 3 may be employed in the above second embodiment.

### [Fourth embodiment]

A fourth embodiment will be described with reference to FIG. 4. Different points from the third embodiment will be described, and the others are omitted. FIG. 4 is a perspective view schematically showing a part 30b of the exterior surface of the sealing substrate 30 in the first embodiment. The exterior surface 30b is provided with asperities having streaky ridges. The value of the surface roughness (Ra) of the exterior surface 30b is the above predetermined value or more. The method of forming such asperities having the streaky ridges is not particularly limited, and the asperities may be formed by, for example, the press working.

### [Fifth embodiment]

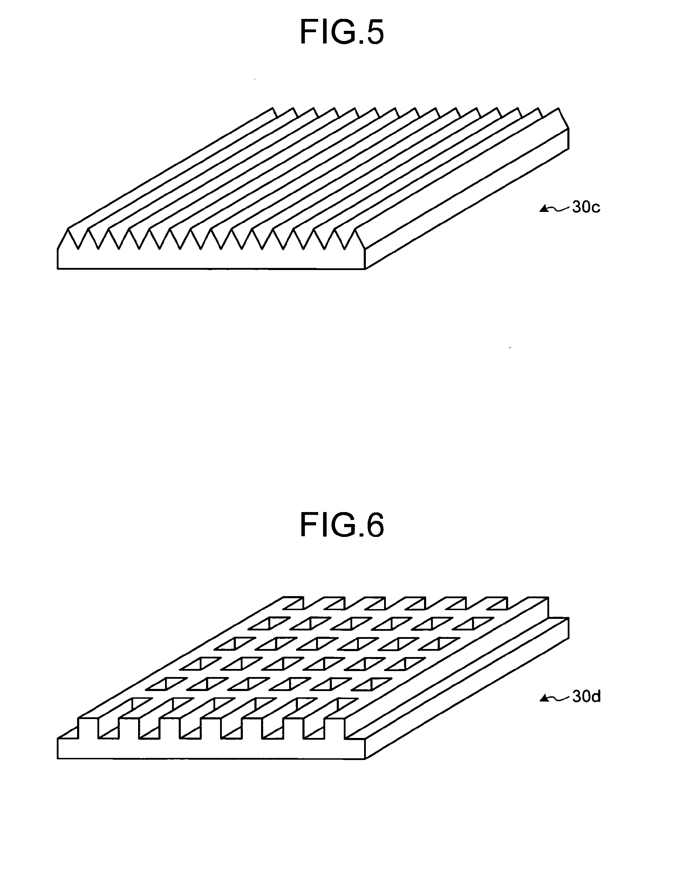

A fifth embodiment will be described with reference to FIG. 5. The different points from the third embodiment will be described, and the others are omitted. FIG. 5 is a perspective view schematically showing a part 30c of the exterior surface of the sealing substrate 30 in the first embodiment. The exterior surface 30c is provided with accordion-shaped asperities. The value of the surface roughness (Ra) of the exterior surface 30c is the above predetermined value or more. The method of forming such accordion-shaped asperities is not particularly limited, and the asperities may be formed by, for example, the press working.

### [Sixth embodiment]

A sixth embodiment will be described with reference to FIG. 6. The different points from the third embodiment will be described, and the others are omitted. FIG. 6 is a perspective view schematically showing a part 30d of the exterior surface of the sealing substrate 30 in the first embodiment. The exterior surface 30d is provided with curb-shaped asperities. The value of the surface roughness (Ra) of the exterior surface 30d is the above predetermined value or more. The method of forming such curb-shaped asperities is not particularly limited, and the asperities may be formed by, for example, the press working.

### [Other embodiments]

In the other embodiment, the supporting substrate may be formed of the material having the thermal conductivity of 2 W/m.K or more, as well as the surface roughness (Ra value) of the surface that composes the exterior may be 10 nm or more and 1 mm or less. In this case, the interface between the supporting substrate and the organic EL element is also provided with the insulating layer. Further, as with the above embodiments, the organic EL device is sealed by attaching the sealing substrate. Either type of the top emission type or the bottom emission type may be employed for the organic EL device of the present invention.

### 2. Method for manufacturing organic EL device of the present invention

The method for manufacturing the organic EL device of the present invention has a step of attaching the supporting substrate on which the organic electroluminescent element is mounted to the sealing substrate. Either one of the supporting substrate or the sealing substrate is formed of the material having the thermal conductivity of 2 W/m·K or more, and an insulative adhesive material having a predetermined viscosity is used to laminate the supporting substrate to the sealing substrate.

The viscosity of the insulative adhesive material before being cured is preferably 10 mPa·s or more and 100 mPa·s or less and more preferably 20 mPa·s or more and 80 mPa·s or less. By adjusting to such a viscosity, the entire organic EL element can be easily coated with the insulative adhesive material. Highly thermally conductive materials are often also electrically conductive materials. Therefore, if the film thickness of the insulating layer becomes too thin, it is likely that the organic EL element is contacted with fine projections and asperities on the surface of the substrate formed of the electrically conductive material, thus causing the short-circuit. By making the viscosity of the insulative adhesive material the above lower limit or more, it is possible to make the film thickness of the insulating layer an appropriate thickness. If the viscosity of the insulative adhesive material is too low, when there are tilts or ridges on the substrate, after applying the insulative adhesive material on the substrate, the insulative adhesive material runs off along the tilts and the ridges, and thus it is difficult to make the uniform film. By adjusting to the preferable viscosity as described above, the layer having the uniform film thickness can be formed easily. On the other hand, when the viscosity of the insulative adhesive material is too high, it becomes difficult to apply on the substrate. By determining the upper limit of the viscosity as described above, an application step can be carried out easily. When the viscosity is too high, the film of the formed insulating layer is easily thickened. By determining the upper limit of the viscosity as described above, it is possible to easily form the insulating layer having the uniform and appropriate thickness.

It is preferable to apply the insulative adhesive material so that the organic EL element provided on the supporting substrate is entirely covered. As described above, the insulating layer is allowed to exist between the organic EL element and the substrate having the predetermined thermal conduction. As the insulative adhesive material, the materials that can constitute the insulating layer, which were described in the first embodiment in the above "1. Organic EL device of the present invention" are likewise shown as examples. As described above, the supporting substrate and the sealing substrate are fixed with the insulative adhesive material to shield the organic EL element from the ambient air and seal the organic EL device.

Hereinafter, taking the case of manufacturing the organic EL device in the above first embodiment as an example, this example will be described in more detail. First, the respective layers that compose the organic EL element 20, e.g., the anode, the organic light-emitting layer and the cathode are sequentially stacked on the supporting substrate 10, thus forming an element-mounted substrate on which the organic EL element has been mounted. On the other hand, the insulative adhesive material whose viscosity has been adjusted to a predetermined level is applied in advance on one surface of the sealing substrate 30. As the application method of the insulative adhesive material, the coating methods such as the microgravure coating method, the bar coating method, the roll coating method and the slit coating method, and the printing method such as the gravure printing method, the screen printing method and the flexographic printing method may be employed. Depending on the type of the insulative adhesive material, this is applied simply and easily by the bar coating method. The surface of the sealing substrate 30, on which the insulative adhesive material has been applied, is positioned so that the organic EL element 20 is entirely covered with the insulative adhesive material, and the sealing substrate 30 and the element-mounted substrate are laminated. The insulative adhesive material is cured to form the insulating layer 40. As described above, the entire organic EL element is shielded from the ambient air, and the sealing substrate and the element-mounted substrate are fixed.

As more specific one embodiment, laminating may be performed as follows. First, the insulative adhesive material whose viscosity has been adjusted to the predetermined level is applied on one entire surface of the sealing substrate 30 using the coating method such as the bar coating method. The sealing substrate 30 is arranged in a lower position so that the surface on which the insulative adhesive material has been applied turns up, and the element-mounted substrate is arranged in an upper position so that the organic EL element turns down, and then, they are positioned so that the entire surface of the organic EL element 20 on the supporting substrate 10 is covered with the insulative adhesive material. The sealing substrate 10 and the element-mounted substrate are laminated. After being laminated, they are reversed so that the sealing substrate becomes the upper layer. Pressure is added appropriately due to the weight of a sealing substrate 10, thus adhering and fixing the sealing substrate 30 and the supporting substrate 10. This form is suitable in that dripping is prevented when an amount of the applied insulative adhesive material is large or when the viscosity of the insulative adhesive material is adjusted to a low level. If no problem such as the dripping occurs even when the insulative adhesive material applied on the sealing substrate 30 is placed downward, initially the sealing substrate may be arranged at the upper side and the element-mounted substrate may be arranged at the lower side to laminate them. As the above embodiment, by adjusting the viscosity of the insulative adhesive material to the predetermined level as described above, it is possible to cure the insulative adhesive material with adding the appropriate pressure due to the weight of the sealing substrate 10.

### Examples

### [Example 1: Cu sealing substrate, whole surface sealing]

An organic EL element was made by the following method using a glass substrate of 200x200 mm (thermal conductivity: 1.0 W/m.K) on which multiple ITO transparent conductive film patterns for the organic EL element having a size of 30x40 mm had been formed. The ITO transparent conductive film obtained by forming the film having a thickness of about 150 nm by a sputtering method was patterned.

First, an auxiliary electrode was formed on a fringe portion of the element. That is, a film of Mo/Al/Mo is formed on the glass substrate with the ITO patterns by a vacuum deposition method, and subsequently the auxiliary electrode patterns were formed using a photolithography method and an acid-based etchant.

Subsequently, a film was formed using a suspension of poly(3,4)ethylenedioxythiophene/polystyrene sulfonate (Bytron P TP A1 4083 supplied from HC Stark Vtech) by a spin coating method, and dried on a hotplate at 200°C for 10 minutes in air to form a hole injection layer having the thickness of 70 nm. Subsequently, an unnecessary portion of the hole injection layer in the fringe of the organic EL element was wiped and removed with a wiper impregnated with water.

Then, a solution of 1.5% by weight of a polymer organic light-emitting material (Lumation GP1300 supplied from Sumation Co., Ltd.) was made using a solvent obtained by mixing anisole and cyclohexylbenzene at a weight ratio of 1:1, and this solution was applied using a capillary coating apparatus (supplied from Hirano Tecseed Co., Ltd.) on the substrate on which the hole injection layer had been formed to form a light-emitting layer. Subsequently, the unnecessary portion of the light-emitting layer in the fringe of the element was wiped with the organic solvent, and then the layer was dried under vacuum (pressure: 1×10⁻⁴ Pa or less, temperature: about 100°C, heated for 60 minutes).

After that, the substrate was transferred to a vapor deposition chamber, aligned with a cathode mask, and the cathode was deposited. The vapor deposition of the cathode was performed by heating Ba metal by a resistance heating method, depositing it at a deposition rate of 2 angstroms (0.2 nm)/sec to have the film thickness of 50 angstroms (5 nm), and depositing A1 at a deposition rate of 2 angstroms (0.2 nm)/sec to have the film thickness of 1500 angstroms (150 nm) using an electron beam deposition method. After forming the cathode, the substrate was transferred from the vapor deposition chamber to a glove box under an inert atmosphere without being exposed to the air.

Then, a Cu sealing substrate (thickness: 2 mm, thermal conductivity: 398 W/m.K) was prepared. One plane surface of the Cu sealing substrate has a surface roughness (Ra) of about 52 nm. PX681C (supplied from Robnor Resins) that was a thermosetting resin was applied as an insulative adhesive material on a whole surface of the other plane surface. After applying on the whole surface, the Cu sealing substrate was placed in the globe box under the inert atmosphere, aligned with the substrate on which the cathode had been formed, subsequently they were laminated, further kept in vacuum, then back to an atmospheric pressure, and heated to cure the thermosetting resin and fix the element substrate and the sealing substrate to manufacture an organic EL device. The viscosity of the thermosetting resin used was 50 mPa·s before being cured, and a distance between the organic EL element and the sealing substrate was 10 µm after being cured.

The surface roughness (Ra) of the Cu sealing substrate was measured using an atomic force microscope (supplied from Seiko Instruments Inc.). Further, the viscosity of the thermosetting resin before being cured was measured using a rotary viscometer.

A direct current voltage was applied to the obtained organic EL device, a temperature distribution on an element surface (light extraction surface side) at a time point of 1500 cd/m² was measured using a thermography apparatus (supplied from Nippon Avionics Co., Ltd.), and it was found that the temperature consisted in the range of 50 to 63°C throughout the whole surface. Schematic views of the thermography are shown in FIG. 8, which show the results of measuring the temperature distribution. In FIG. 8, the result of present Example 1 (b) and the result of following Comparative Example 1 (a) (using a glass sealing substrate) are compared.

The direct current was applied to the obtained organic EL device, and a current-voltage property and a current-brightness property were measured. From them, a light-emitting area of the organic EL device was standardized, and a relationship between a current density (unit: A/cm²) and an electroluminescence efficiency (EL efficiency, unit: cd/m²) was measured. The result of the measurement in present Example 1 is shown together with the result of the measurement in Comparative Example 1 (using the glass sealing substrate) in FIG. 9. In FIG. 9, a horizontal axis indicates the current density and a vertical axis indicates the electroluminescence efficiency. As is shown in FIG. 9, it has been demonstrated that present Example 1 using the sealing substrate made of copper is more excellent in electroluminescence efficiency. Therefore, it has been demonstrated that the organic EL device of present Example 1 has the flat temperature distribution, is excellent in heat radiation property and excellent in electroluminescence efficiency.

### [Comparative Example 1: Glass sealing substrate, whole surface sealing]

An organic EL device was made in the same manner as in Example 1, except that the glass substrate (thermal conductivity: 1.0 W/m·K) was used for the sealing substrate. The temperature distribution in the element was measured under the same condition as in Example 1, and the temperature distribution was large, a maximal temperature was 83°C in a central portion and a minimal temperature was 33°C in a fringe portion. The result is as shown in FIG. 9(a). The result of measuring the electroluminescence efficiency in the same manner as in Example 1 is as shown in FIG. 10.

### [Comparative Example 2: Cu substrate, fringe sealing]

An organic EL device was made in the same manner as in Example 1, except that the sealing material was applied not on the whole surface of the sealing substrate but on a peripheral portion alone that surrounds the organic EL element viewed from a laminated direction of the organic EL element (i.e., a direction perpendicular to the plane surface of the element). That is, the organic EL device using the Cu sealing substrate but not given the whole surface covering of the organic EL element using the thermosetting resin was made. For sealing, the thermosetting resin was applied on the peripheral portion alone using a dispenser. The direct current voltage was applied to the organic EL device made, but no light emission was elicited. It was inferred that this was caused by generating the short-circuit between the Cu sealing substrate and the cathode.

### [Comparative Example 3: Cu substrate, whole surface sealing, wrong viscosity of sealing material]

An organic EL device was made in the same manner as in Example 1, except that the viscosity of the sealing material used for the whole surface sealing was 5 mPa·s before being cured. The direct current voltage was applied to the organic EL device made, but no light emission was elicited. It was inferred that this was caused by generating the short-circuit between the Cu sealing substrate and the cathode.

### [Example 2: Top emission, Cu supporting substrate, glass sealing substrate, whole surface sealing]

In Example 2, the material combination of the supporting substrate and the sealing substrate in Example 1 is reversed. That is, the Cu substrate was used for the supporting substrate, the glass substrate is used for the sealing substrate, and the whole surface is sealed. A device of Example 2 can be manufactured in the same manner as in Example 1, except that the side on the Cu substrate, on which the organic EL element is formed, is also provided with the insulating layer for flatness and wiring formation on the surface on which the organic EL element is formed. This can form the element whose surface temperature distribution is uniform as with Example 1 in the so-called top emission type element in which the light is extracted from a sealing substrate side.
As describe above, it is possible in Examples of the present invention to uniformize the temperature distribution in the device.

### INDUSTRIAL APPLICABILITY

As described above, the present invention is useful in industrial fields associated with the organic EL device.

## Claims

1. An organic electroluminescent device comprising a supporting substrate, a sealing substrate and an organic electroluminescent element, the device comprising:
the organic electroluminescent element mounted on the supporting substrate and enclosed between the supporting substrate and the sealing substrate, and
an insulating layer that covers the organic electroluminescent element,
wherein the supporting substrate and/or the sealing substrate adhered to the insulating layer is formed of a material having a thermal conductivity of 2 W/m·K or more, and
wherein one surface of the supporting substrate and/or one surface of the sealing substrate formed of the material having the thermal conductivity, which is a surface constituting an exterior of the organic electroluminescent device, has a surface roughness (Ra value) of 10 nm or more and 1 mm or less.

2. The organic electroluminescent device according to claim 1, wherein the thermal conductivity is 10 W/m.K or more.

3. The organic electroluminescent device according to claim 2, wherein the material having the thermal conductivity is any one member or two or more members selected from the group consisting of metals, ceramics and inorganic oxides.

4. The organic electroluminescent device according to claim 3, wherein the material having the thermal conductivity is one metal or a composite material of two or more members selected from the group consisting of copper, aluminum, iron, nickel, chromium, tin, alloys thereof and an SUS alloy.

5. The organic electroluminescent device according to claim 1, wherein the supporting substrate and the sealing substrate are adhered by the insulating layer.

6. The organic electroluminescent device according to claim 1, wherein the insulating layer is formed of one member or two or more members selected from the group consisting of epoxy resin, acryl resin, polyimide resin, silicone resin, phenol resin and urethane resin.

7. The organic electroluminescent device according to claim 1, wherein the insulating layer contains a thermally conductive filler.

8. The organic electroluminescent device according to claim 7, wherein the thermally conductive filler is a fine particle of an inorganic oxide.

9. A method for manufacturing an organic electroluminescent device by laminating a supporting substrate with an organic electroluminescent element mounted thereon and a sealing substrate,
wherein either one of the supporting substrate or the sealing substrate or both formed of a material having a thermal conductivity of 2 W/m·K or more, and the method comprises:
providing the organic electroluminescent element on the supporting substrate,
covering the organic electroluminescent element provided on the supporting substrate entirely with an insulative adhesive material having a viscosity of 10 mPa·s or more and 100 mPa·s or less before being cured,
laminating the supporting substrate and the sealing substrate, and
sealing the organic electroluminescent element by curing the insulative adhesive material and thereby adhering the supporting substrate and the sealing substrate.

10. The method for manufacturing the organic electroluminescent device according to claim 9,
wherein the viscosity of the insulative adhesive material before being cured is 20 mPa·s or more and 80 mPa·s or less.

11. A method for manufacturing an organic electroluminescent device by laminating a supporting substrate with an organic electroluminescent element mounted thereon and a sealing substrate,
wherein either one of the supporting substrate or the sealing substrate or both is formed of a material having a thermal conductivity of 2 W/m.K or more, and the method comprises:
providing the organic electroluminescent element on the supporting substrate,
applying an insulative adhesive material having a viscosity of 10 mPa·s or more and 100 mPa·s or less before being cured to one surface of the sealing substrate,
laminating the surface with the insulative adhesive material to cover the organic electroluminescent element, and
sealing the organic electroluminescent element by curing the insulative adhesive material under pressure due to the weight of the sealing substrate or the supporting substrate and thereby forming an insulative adhesive material layer that covers the organic electroluminescent element and adheres the supporting substrate and the sealing substrate.
